# EUROPEAN PATENT APPLICATION

(11) **EP 4 329 111 A1**
(43) Date of publication of application: **28.02.2024**
(21) Application number: 22814790.6
(22) Date of filing: 14.03.2022
(51) Int. Cl.: H01R 43/26

(54) **EXTRACTOR AND SUBRACK**

(30) Priority: 04.06.2021 CN 202110624161
(71) Applicant: ZTE Corporation, Shenzhen, Guangdong 518057 (CN)
(72) Inventor: CAO, Shuichun, Shenzhen, Guangdong 518057 (CN)
(74) Representative: Canzler & Bergmeier Patentanwälte Partnerschaft mbB
(86) International application number: PCT/CN2022/080660
(87) International publication number: WO 2022/252742

(57) **Abstract**

Provided is an extractor (10), which comprises a main body part (1). The main body part (1) comprises a fixing seat (11), a jaw structure (12) and a locking structure (13), wherein the jaw structure (12) is connected to the fixing seat (11) and is capable of rotating relative to the fixing seat (11); and the locking structure (13) is arranged on the jaw structure (12) and is capable of matching the fixing seat (11) to lock the jaw structure (12), so as to prevent the jaw structure (12) from rotating relative to the fixing seat (11). By means of the arrangement of the locking structure (13), the jaw structure (12) can be locked; and in a locked state, the jaw structure (12) cannot rotate relative to the fixing seat (11), and accordingly the jaw structure cannot drive a board (20) to move outwards, thereby preventing the board (20) and an optical fiber from falling off due to an accidental touch, such that the safety of the board (20) is improved. Further provided is a subrack comprising the extractor (10).

## Description

### CROSS-REFERENCE TO RELATED APPLICATIONS

The present disclosure claims the priority of Chinese patent application No. 202110624161.8 titled "EXTRACTOR and SUBRACK" filed with the CNIPA on June 4, 2021, the entire contents of which are incorporated herein by reference.

### TECHNICAL FIELD

Embodiments of the present disclosure of relate to, but are not limited to, the technical field of communication devices, and in particular, to an extractor and a subrack including the extractor.

### BACKGROUND

The board of a communication device needs to be frequently replaced. Generally, an extractor is installed on the board to facilitate plugging, extraction and replacement of the board. A wrench part of the extractor plays a role of a lever, which can reduce the force required for plugging and extraction of the board. When the wrench part of the extractor rotates inwards (i.e., approaching the board), the board can be plugged into the plug-in frame. When the wrench part rotates outwards (i.e., away from the board), the board can be extracted from the plug-in frame.

However, after the board is plugged into the plug-in frame, if a worker accidentally touches the wrench part outwards during maintenance or troubleshooting of the equipment, the wrench part may drive the board out of the plug-in frame, thereby damaging the board or causing an optical fiber to fall off.

### SUMMARY

The present disclosure provides an extractor and a subrack.

In a first aspect, an embodiment of the present disclosure provides an extractor, including a main body part, wherein the main body part includes a fixing seat, a jaw structure and a locking structure, the jaw structure being connected to the fixing seat and rotatable relative to the fixing seat; and
the locking structure is arranged on the jaw structure and matchable with the fixing seat to lock the jaw structure, so as to prevent the jaw structure from rotating relative to the fixing seat.

In some embodiments, the fixing seat is provided with a first recess at a first end, and the jaw structure is partially received in the first recess and connected to the fixing seat via a first connecting shaft in the first recess; and
under the condition that the jaw structure is in a locked state, the locking structure abuts against an edge of the fixing seat at the position of the first recess.

In some embodiments, the locking structure includes a detent, a press block, and a first elastic member, and the jaw structure includes a first cavity in which the press block and the first elastic member are received;
the detent is connected to the jaw structure via a second connecting shaft and rotatable around the second connecting shaft, a first end of the detent is meshed with a side wall of the press block, and a second end of the detent is abuttable against the edge of the fixing seat; and
one end of the first elastic member is connected to an inner wall of the first cavity, and the other end of the first elastic member is connected to an end of the press block.

In some embodiments, under the condition that the jaw structure is in a locked state, the second end of the detent abuts against the edge of the fixing seat at the position of the first recess; and when the jaw structure is in an unlocked state, the first elastic member is in a compressed state, and the second end of the detent is separated from the edge of the fixing seat.

In some embodiments, the extractor further includes a wrench part having a handle and a latch structure, the latch structure is connected to one end of the handle, and the wrench part is detachably connected to the main body part via the latch structure.

In some embodiments, the jaw structure includes a second cavity, a third recess being provided inside a cavity wall of the second cavity;
the handle is provided with a second recess in which the latch structure is received, the latch structure includes a latch and a second elastic member, the latch includes a hook part and a connection part which are interconnected with each other, the connection part is connected to the second recess via a third connecting shaft, and the second elastic member is connected to the second recess via a fourth connecting shaft and abuts against the connection part of the latch; and
under the condition that the wrench part is connected to the main body part, the hook part is received in the second cavity and engaged with the third recess.

In some embodiments, the extractor further includes a detection part connected to the fixing seat and configured to send a control signal to a board upon detecting that the jaw structure is rotated in a direction away from the fixing seat, so that the board performs data backup according to the control signal.

In some embodiments, the detection part includes a switch and a signal generator, wherein the switch is connected to the jaw structure and configured to trigger, upon detecting that the jaw structure is rotated in the direction away from the fixing seat, the signal generator to generate the control signal.

In another aspect, an embodiment of the present disclosure further provides a subrack, including a subrack outer frame, at least one board and at least one extractor as described above, wherein the at least one board and the at least one extractor are arranged in an accommodation space of the subrack outer frame, and a fixing seat of the extractor is connected to the board and the subrack outer frame.

In some embodiments, the subrack includes a plurality of boards and a plurality of extractors, and each board is connected to the fixing seats of two extractors.

According to the embodiment of the present disclosure, the extractor includes a main body part including a fixing seat, a jaw structure and a locking structure, the jaw structure being connected to the fixing seat and rotatable relative to the fixing seat; and the locking structure is arranged on the jaw structure and matchable with the fixing seat to lock the jaw structure, so as to prevent the jaw structure from rotating relative to the fixing seat. According to the embodiment of the present disclosure, by means of the locking structure, the jaw structure can be locked so that in a locked state, the jaw structure cannot rotate relative to the fixing seat, and accordingly, the jaw structure cannot drive the board to move outwards, thereby preventing the board or an optical fiber from falling off due to an accidental touch and improving the safety of the board.

### BRIEF DESCRIPTION OF DRAWINGS

FIG. 1 is a schematic diagram of a jaw structure according to an embodiment of the present disclosure in a locked state;
FIG. 2 is a schematic diagram of a jaw structure according to an embodiment of the present disclosure in an unlocked state;
FIG. 3 is a schematic diagram of a locking structure according to an embodiment of the present disclosure;
FIG. 4 is a schematic diagram of a main body part and a wrench part according to an embodiment of the present disclosure in a separated state;
FIG. 5 is a schematic diagram of a main body part and a wrench part according to an embodiment of the present disclosure in a connected state;
FIG. 6 is a schematic diagram of a detection part of the extractor according to an embodiment of the present disclosure in a locked state;
FIG. 7 is a schematic diagram of a detection part of the extractor according to an embodiment of the present disclosure in an unlocked state;
FIG. 8 is a schematic diagram of an extractor according to an embodiment of the present disclosure in an unlocked state;
FIG. 9 is a schematic diagram of an extractor according to an embodiment of the present disclosure in a locked state; and
FIG. 10 is a schematic structural diagram of a subrack according to an embodiment of the present disclosure.

### DETAIL DESCRIPTION OF EMBODIMENTS

Example embodiments will be described more sufficiently below with reference to the accompanying drawings, but which may be embodied in different forms and should not be construed as limited to the embodiments set forth herein. Rather, these embodiments are provided so that the present disclosure will be thorough and complete, and will fully convey the scope of the present disclosure to those skilled in the art.

As used herein, the term "and/or" includes any and all combinations of one or more of the associated listed items.

The terminology used herein is for the purpose of describing specific embodiments only and is not intended to limit the present disclosure. As used herein, the singular forms "a", "an" and "the" are intended to include the plural forms as well, unless the context clearly indicates otherwise. It will be further understood that as used herein, the terms "comprise" and/or "consist of ..." specify the presence of stated features, integers, steps, operations, elements, and/or components, but do not preclude the presence or addition of one or more other features, integers, steps, operations, elements, components, and/or groups thereof.

Embodiments described herein may be described with reference to plan and/or sectional views in idealized representations of the present disclosure. Accordingly, the example illustrations may be modified in accordance with manufacturing techniques and/or tolerances. Accordingly, the embodiments are not limited to the embodiments shown in the drawings, but include modifications of configurations formed based on a manufacturing process. Thus, the regions illustrated in the figures have schematic properties, and the shapes of the regions shown in the figures illustrate specific shapes of regions of elements, but are not intended to be limiting.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

An embodiment of the present disclosure provides an extractor, which is an assistance structure for plugging a board in or extracting a board from a subrack. Herein, the board refers to a functional sub-module in the subrack which can be quickly plugged, extracted and replaced.

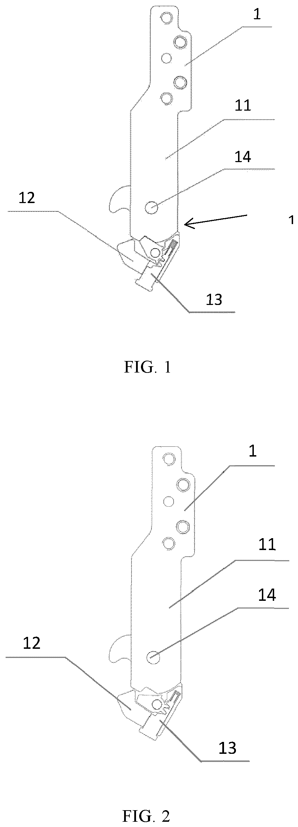

As shown in FIGs. 1 and 2, the extractor according to the embodiment of the present disclosure includes a main body part 1. The main body part 1 includes a fixing seat 11, a jaw structure 12 and a locking structure 13. The jaw structure 12 is connected to the fixing seat 11 and rotatable relative to the fixing seat 11. The locking structure 13 is arranged on the jaw structure 12 and matchable with the fixing seat 11 to lock the jaw structure 12, so as to prevent the jaw structure 12 from rotating relative to the fixing seat 11.

According to the embodiment of the present disclosure, the extractor includes a main body part 1. The main body part 1 includes a fixing seat 11, a jaw structure 12 and a locking structure 13. The jaw structure 12 is connected to the fixing seat 11 and rotatable relative to the fixing seat 11. The locking structure 13 is arranged on the jaw structure 12 and matchable with the fixing seat 11 to lock the jaw structure 12, so as to prevent the jaw structure 12 from rotating relative to the fixing seat 11. According to the embodiment of the present disclosure, by means of the locking structure 13, the jaw structure 12 can be locked so that in a locked state, the jaw structure 12 cannot rotate relative to the fixing seat 11, and accordingly, cannot drive the board to move outwards, thereby preventing the board or an optical fiber from falling off due to an accidental touch and improving the safety of the board.

In some embodiments, referring to FIGs. 1 to 3, the fixing seat 11 is provided with a first recess 111 at a first end, and the jaw structure 12 is partially received in the first recess 111 and connected to the fixing seat 11 via a first connecting shaft 14 in the first recess 111. As shown in FIG. 1, when the jaw structure 12 is in a locked state, the locking structure 13 abuts against an edge of the fixing seat 11 at the position of the first recess 111. In some embodiments, the first recess 111 may be a slot extending through two opposite sides of the fixing seat 11.

The fixing seat 11 and the jaw structure 12 are each provided with a through hole into which the first connecting shaft 14 is inserted. The first connecting shaft 14 and the fixing seat 11 are in interference fit, to prevent the first connecting shaft 14 from falling off the fixing seat 11. The first connecting shaft 14 and the jaw structure 12 are in clearance fit, to ensure that the jaw structure 12 can rotate around the first connecting shaft 14 (while the fixing seat 11 remains fixed).

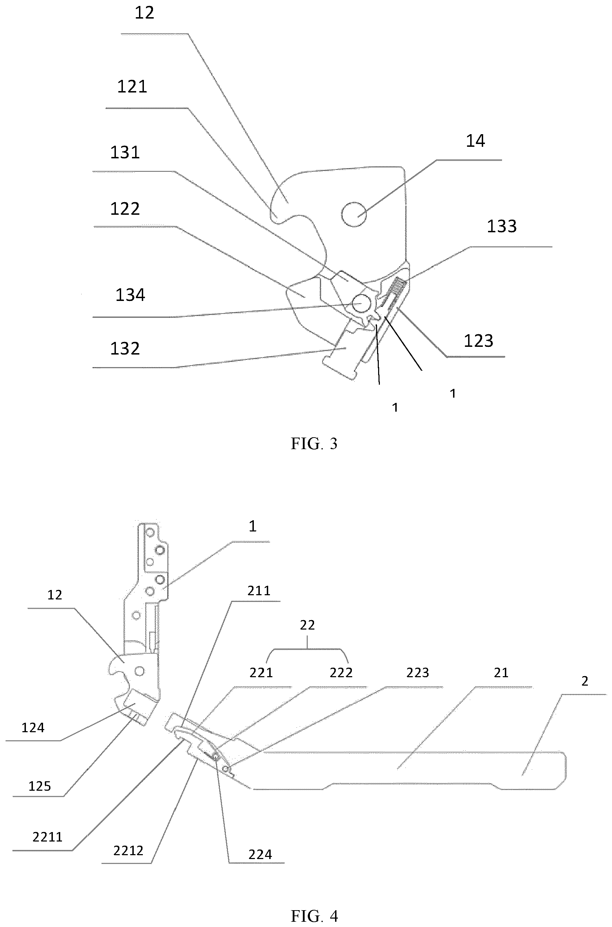

In some embodiments, referring to FIGs. 1 and 3, the locking structure 13 includes a detent 131, a press block 132, and a first elastic member 133, and the jaw structure 12 includes a first cavity 123 in which the press block 132 and the first elastic member 133 are received. The detent 131 is connected to the jaw structure 12 via a second connecting shaft 134 and rotatable around the second connecting shaft 134, a first end of the detent 131 is meshed with a side wall of the press block 132, and a second end of the detent 131 is abuttable against the edge of the fixing seat 11. One end of the first elastic member 133 is connected to an inner wall of the first cavity 123, and the other end of the first elastic member 133 is connected to one end of the press block 132.

The detent 131 and the jaw structure 12 are each provided with a through hole in which the second connecting shaft 134 is inserted. The second connecting shaft 134 and the jaw structure 12 are in interference fit, to prevent the second connecting shaft 134 from falling off. The second connecting shaft 134 and the detent 131 are in clearance fit, so that the detent 131 may be rotatable around the second connecting shaft 134. The first elastic member 133 may be a compression spring which is sleeved on a shaft at a top end of the press block 132. The first cavity 123 has an opening, and the detent 131 is located at the position of the opening and protrudes out of the opening. In other words, a first end of the detent 131 is inside the first cavity 123, while a second end of the detent 131 is outside the first cavity 123, so as to abut against a lower edge of the fixing seat 11. A first tooth 132a is provided on the side wall of the press block 132, and a second tooth 131a is provided on the first end of the detent 131. The first tooth 132a and the second tooth 131a are mutually meshed to implement rack and pinion fit between the press block 132 and the detent 131, so that the press block 132 can drive the detent 131 to rotate.

As shown in FIG. 1, when the jaw structure 12 is in a locked state, the second end of the detent 131 abuts against the edge of the fixing seat 11 at the position of the first recess 111 of the fixing seat 11, and at this time, the first elastic member 133 is in a natural state (not compressed). As shown in FIG.2, when the jaw structure 12 is in an unlocked state, the first elastic member 133 is in a compressed state, and the second end of the detent 131 is separated from the edge of the fixing seat 11.

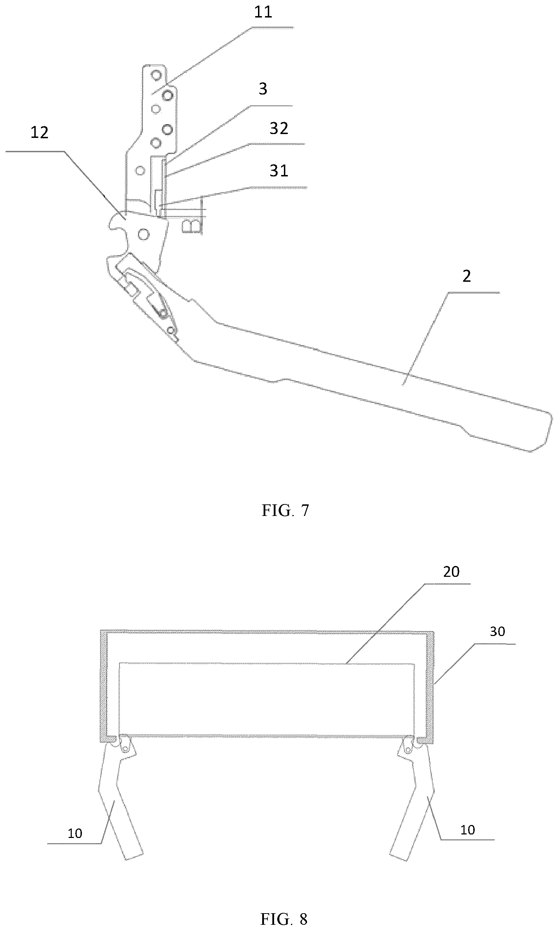

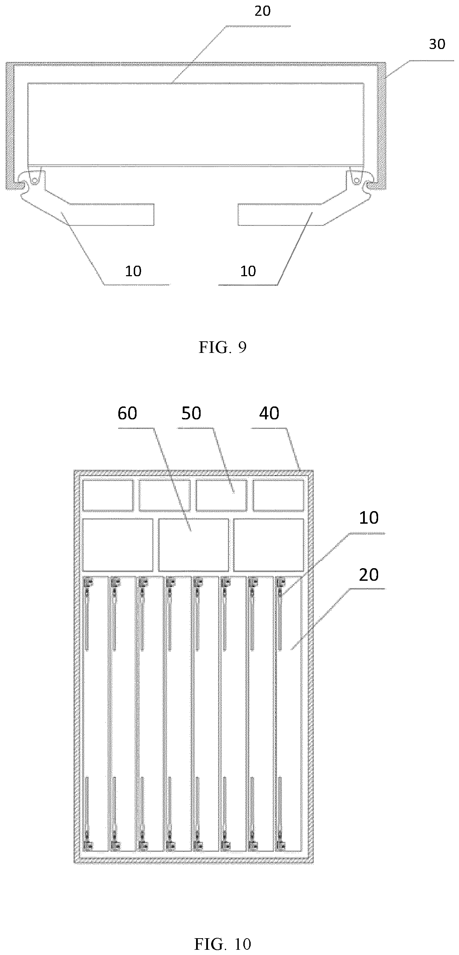

In some embodiments, as shown in FIG. 3, the jaw structure 12 includes a first jaw 121 and a second jaw 122 which are interconnected with each other or may be integrally formed. Referring to FIG. 8, in the unlocked state, the second jaw 122 abuts against an outer wall of a plug-in frame 30. Referring to FIG. 9, in the locked state, the first jaw 121 abuts against an inner wall of the plug-in frame 30.

When the jaw structure 12 is in the locked state, since the detent 131 abuts against the fixing seat 11, the jaw structure 12 cannot rotate around the first connecting shaft 14, thereby implementing a locking function. If the press block 132 is pressed from the outside of the extractor, the press block 132 overcomes an elastic force of the first elastic member 133 to move inwards (i.e., towards the inside of the first cavity 123). Through the meshing transmission between the first tooth of the press block 131 and the second tooth of the detent 131, the press block 132 drives the detent 131 to rotate (for the extractor shown in FIGs. 1 and 2, the detent 131 then rotates in a counter-clockwise direction), so that the jaw structure 12 is changed from the locked state to the unlocked state, and the extractor completes the unlocking. When the jaw structure 12 is in the unlocked state, the detent 131 is separated from the fixing seat 11, and then, the jaw structure 12 of the extractor may be rotated around the first connecting shaft 14 in a direction away from the board, so that the board fixed on the fixing seat 11 is extracted from the plug-in frame. It should be noted that, from the locked state to the unlocked state, the press block 132 is pressed to unlock, and simply by releasing the press block 132, the press block 132 can automatically reset under the elastic force of the first elastic member 133, and correspondingly drive the detent 131 to rotate (for the extractor shown in FIGs. 1 and 2, the detent 131 then rotates in a clockwise direction), automatically implementing locking.

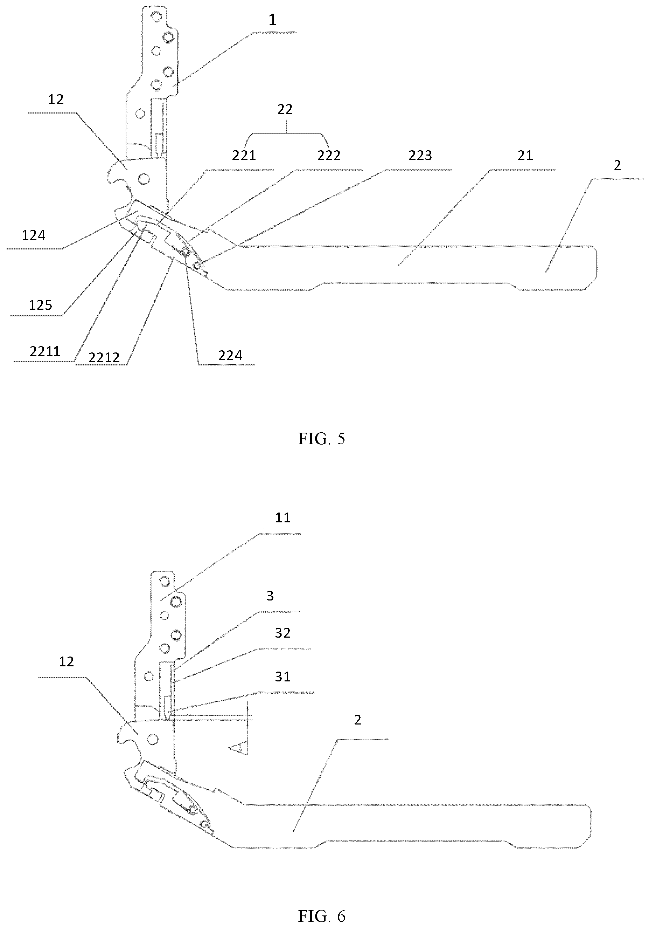

In some embodiments, as shown in FIGs. 4 and 5, the extractor further includes a wrench part 2 including a handle 21 and a latch structure 22, the latch structure 22 is connected to one end of the handle 21, and the wrench part 2 is detachably connected to the main body part 1 via the latch structure 22.

According to the embodiments of the present disclosure, by detachably connecting the wrench part 2 to the main body part 1, the wrench part 2 can be connected to the main body part when the board is desired to be plugged in or extracted from the subrack, and detached from the main body part 1 after the operation is completed. In the case of plugging the board into the subrack, the extractor occupies less space after the wrench part 2 is detached, and the wrench part 2 will not block any optical fiber or air channel in front of the board any more, thereby facilitating maintenance of the subrack by a worker and improving the ventilation performance of the board.

In some embodiments, as shown in FIGs. 4 and 5, the jaw structure 12 includes a second cavity 124 provided with a third recess 125 inside a cavity wall thereof. The handle 21 is provided with a second recess 211 in which the latch structure 22 is received. The latch structure 22 includes a latch 221 and a second elastic member 222. The latch 221 includes a hook part 2211 and a connection part 2212 interconnected with each other. The connection part 2212 is connected to the second recess 211 via a third connecting shaft 223. The second elastic member 222 is connected to the second recess 211 via a fourth connecting shaft 224 and abuts against the connection part 2212 of the latch 221. When the wrench part 2 is connected to the main body part 1, the hook part 2211 is received in the second cavity 124 and engaged with the third recess 125.

The wrench part 2 may be inserted along a direction of the second cavity 124, so that the wrench part 2 and the main body part 1 are combined into a functionally complete extractor, as shown in FIG. 5. At this time, the hook part 2211 of the latch 221 hooks the third recess 125, so that the wrench part 2 and the main body part 1 are connected into an integral structure. When the connection part 2212 of the latch 221 is pressed, the latch 221 may overcome the elastic force of the second elastic member 222 so that the hook part 2211 is separated from the third recess 125. At this time, the wrench part 2 is unlocked and can be detached from the main body part 1, so that the extractor will not block any optical fiber and the space is saved.

The handle 21 and the connection part 2212 are each provided with a through hole in which the third connecting shaft 223 is inserted. The third connecting shaft 223 and the handle 21 are in interference fit, to prevent the third connecting shaft 223 from falling off. The third connecting shaft 223 and the latch 221 (also the connection part 2212) are in clearance fit, to ensure that the connection part 2212 is rotatable. The second elastic member 222 may be a torsion spring which is sleeved on the fourth connecting shaft 224, an end of the second elastic member 222 abuts against a side wall of the second recess 211, and the other end abuts against the connection part 2212.

In some embodiments, as shown in FIGs. 6 and 7, the extractor further includes a detection part 3 connected to the fixing seat 11 and configured to send a control signal to a board upon detecting that the jaw structure 12 is rotated in a direction away from the fixing seat, so that the board performs data backup according to the control signal.

In some embodiments, the detection part 3 includes a switch 31 and a signal generator 32. The switch 31 is connected to the jaw structure 12 and configured to trigger, upon detecting that the jaw structure 12 is rotated in the direction away from the fixing seat, the signal generator 32 to generate the control signal.

In an embodiment of the present disclosure, the switch 31 is a micro switch, and the signal generator 32 is a printed circuit board (PCB). The micro switch may be fixed on the PCB by wave soldering, while the PCB may be connected to the fixing seat 11 via a screw.

As shown in FIG. 6, when the extractor is in the locked state (i.e., when the board is not extracted), the switch 31 is compressed by the jaw structure 12, and a distance A is provided between the switch 31 and an edge of the jaw structure 12. The switch 31 is in a closed state at this time. As shown in FIG. 7, when the board is desired to be extracted from the subrack, the wrench part 2 is rotated clockwise to drive the jaw structures 12 to rotate clockwise together. The switch 31 is not compressed by the jaw structure 12 at this time. A distance B is provided between the switch 31 and the edge of the jaw structure 12, where B>A. A circuit of the switch is open. The signal generator 32 generates a control signal which is then sent to the board. After receiving the control signal, the board performs data backup. In this manner, during the process of further rotating the wrench part 2 after the board completes the data backup (which takes less time), the data of the board will not be influenced even if the board is shut off and extracted. By means of the detection part 3, automatic backup of the board data can be implemented while the board is extracted, thereby improving the safety and reliability.

The use of the extractor according to the present disclosure will be described in detail below in conjunction with FIGs. 1 to 9. As shown in FIG. 8, when the board 20 is desired to be extracted from the plug-in frame 30 via the extractor 10, the wrench part 2 is connected to the main body part 1 through the latch structure 22. The press block 132 is pressed to unlock the jaw structure 12 and rotate the handle 21 in a direction away from the board 20. During rotation of the handle 21, the switch 31 triggers the board 20 to perform data backup, and the extractor 10 drives the board 20 to come out of the plug-in frame 30. When the board 20 is desired to be plugged into the plug-in frame 30 via the extractor 10, the handle 21 is rotated in a direction toward the board 20. When the extractor 10 reaches the position shown in FIG. 9, the press block 132 is released and the jaw structure 12 is in the locked state. At this time, the wrench part 2 may be separated from the main body part 1, and the extractor 10 locks the board 20 within the plug-in frame 30 and prevents the board 20 from getting out of the plug-in frame 30.

The extractor according to the embodiments of the disclosure has a locking function, can limit the relative rotation between the jaw structure 12 and the fixing seat 11 of the extractor, and ensure that the board is locked in the box and cannot be extracted. The wrench part 2 connects the handle 21 to the main body part 1 with the latch structure 22. The wrench part 2 may be detached by pressing the latch structure 22. When the wrench part 2 is detached, the extractor occupies less space and will not block any optical fiber or air channel in front of the board. The extractor according to the embodiments of the present disclosure further has a function of automatically triggering backup. When the handle 21 of the extractor rotates, the switch 31 is triggered to open, the signal generator 32 sends a control signal to the board and causes the board to perform data backup. The data backup can be automatically completed before the board is extracted. The extractor according to the embodiments of the present disclosure has a function of facilitating extraction of an orthogonal subrack board and a compact and ingenious structure, and the extractor can be conveniently locked and unlocked, has a wrench part that can be easily detached, occupies less space and can improve the comprehensive performance of the subrack.

Based on the same concept, an embodiment of the present disclosure further provides a subrack. As shown in FIG. 10, the subrack includes a subrack outer frame 40, a board 20 and an extractor 10. The board 20 and the extractor 10 are arranged in an accommodation space of the subrack outer frame 40, and a fixing seat of the extractor 10 is connected to the board 10 and the subrack outer frame 40, where the extractor 10 is an extractor as described above.

According to the embodiment of the present disclosure, the subrack includes a subrack outer frame 40, a board 20 and an extractor 10. The board 20 and the extractor 10 are arranged in an accommodation space of the subrack outer frame 40. A fixing seat of the extractor 10 is connected to the board 10 and the subrack outer frame 40. As shown in FIG. 1, the extractor 10 includes a main body part 1. The main body part 1 includes a fixing seat 11, a jaw structure 12 and a locking structure 13. The jaw structure 12 is connected to the fixing seat 11 and rotatable relative to the fixing seat 11. The locking structure 13 is arranged on the jaw structure 12 and matchable with the fixing seat 11 to lock the jaw structure 12, so as to prevent the jaw structure 12 from rotating relative to the fixing seat 11. According to the embodiment of the present disclosure, by means of the locking structure 13, the jaw structure 12 can be locked so that in a locked state, the jaw structure 12 cannot rotate relative to the fixing seat 11, and accordingly, the jaw structure cannot drive the board 20 to move outwards, thereby preventing the board 20 and an optical fiber from falling off due to an accidental touch and improving the safety of the board 20.

In some embodiments, as shown in FIG. 10, a plurality of boards 20 may be provided, and each board 20 is connected to fixing seats of two extractors 10. In this manner, assistance may be provided on both sides of the board 20 at the same time to help plugging or extraction of the board into/from the subrack.

In some embodiments, as shown in FIG. 10, the subrack may further include a power supply module 50, a ventilation module 60, and the like. The power supply module 50 and the ventilation module 60 are also arranged in the accommodation space of the subrack outer frame 40.

Those of ordinary skill in the art will appreciate that all or some operations of the above described method, functional modules/units in the apparatus may be implemented as software, firmware, hardware, and suitable combinations thereof. In a hardware implementation, the division between the functional modules/units mentioned in the above description does not necessarily correspond to the division of physical components; for example, one physical component may have multiple functions, or one function or operation may be performed cooperatively by several physical components. Some or all physical components may be implemented as software executed by a processor, such as a CPU, a digital signal processor or microprocessor, or implemented as hardware, or implemented as an integrated circuit, such as an application specific integrated circuit. Such software may be distributed on a computer-readable medium which may include a computer storage medium (or non-transitory medium) and communication medium (or transitory medium). The term computer storage medium includes volatile and nonvolatile, removable and non-removable media implemented in any method or technology for storage of information such as computer-readable instructions, data structures, program modules or other data, as is well known to those of ordinary skill in the art. The computer storage medium includes, but is not limited to, an RAM, an ROM, an EEPROM, a flash or any other memory technology, a CD-ROM, a digital versatile disc (DVD) or any other optical disc storage, a magnetic cartridge, a magnetic tape, a magnetic disk storage or any other magnetic storage device, or may be any other medium used for storing the desired information and accessible by a computer. Moreover, it is well known to those ordinary skilled in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. In some instances, as would be apparent to one skilled in the art, features, characteristics and/or elements described in connection with a particular embodiment may be used alone or in combination with features, characteristics and/or elements described in connection with another embodiment, unless expressly stated otherwise. It will, therefore, be understood by those skilled in the art that various changes in form and details may be made therein without departing from the scope of the present disclosure as set forth in the appended claims.

## Claims

1. An extractor comprising a main body part, wherein the main body part comprises a fixing seat, a jaw structure and a locking structure, the jaw structure being connected to the fixing seat and rotatable relative to the fixing seat; and
the locking structure is arranged on the jaw structure and matchable with the fixing seat to lock the jaw structure, so as to prevent the jaw structure from rotating relative to the fixing seat.

2. The extractor according to claim 1, wherein the fixing seat is provided with a first recess at a first end, and the jaw structure is partially received in the first recess and connected to the fixing seat via a first connecting shaft in the first recess; and
under the condition that the jaw structure is in a locked state, the locking structure abuts against an edge of the fixing seat at the position of the first recess.

3. The extractor according to claim 2, wherein the locking structure comprises a detent, a press block and a first elastic member, and the jaw structure comprises a first cavity in which the press block and the first elastic member are received;
the detent is connected to the jaw structure via a second connecting shaft and rotatable around the second connecting shaft, a first end of the detent is meshed with a side wall of the press block, and a second end of the detent is abuttable against the edge of the fixing seat; and
one end of the first elastic member is connected to an inner wall of the first cavity, and the other end of the first elastic member is connected to an end of the press block.

4. The extractor according to claim 3, wherein under the condition that the jaw structure is in a locked state, the second end of the detent abuts against the edge of the fixing seat at the position of the first recess; and under the condition that the jaw structure is in an unlocked state, the first elastic member is in a compressed state, and the second end of the detent is separated from the edge of the fixing seat.

5. The extractor according to claim 1, wherein the extractor further comprises a wrench part having a handle and a latch structure, the latch structure is connected to one end of the handle, and the wrench part is detachably connected to the main body part via the latch structure.

6. The extractor according to claim 5, wherein the jaw structure comprises a second cavity, a third recess being provided inside a cavity wall of the second cavity;
the handle is provided with a second recess in which the latch structure is received, the latch structure comprises a latch and a second elastic member, the latch comprises a hook part and a connection part which are interconnected with each other, the connection part is connected to the second recess via a third connecting shaft, and the second elastic member is connected to the second recess via a fourth connecting shaft and abuts against the connection part of the latch; and
under the condition that the wrench part is connected to the main body part, the hook part is received in the second cavity and engaged with the third recess.

7. The extractor according to any one of claims 1 to 6, wherein the extractor further comprises a detection part connected to the fixing seat and configured to send a control signal to a board upon detecting that the jaw structure is rotated in a direction away from the fixing seat, so that the board performs data backup according to the control signal.

8. The extractor according to claim 7, wherein the detection part comprises a switch and a signal generator, wherein the switch is connected to the jaw structure and configured to trigger, upon detecting that the jaw structure is rotated in the direction away from the fixing seat, the signal generator to generate the control signal.

9. A subrack comprising a subrack outer frame, at least one board and at least one extractor according to any one of claims 1 to 8, wherein the at least one board and the at least one extractor are arranged in an accommodation space of the subrack outer frame, and the fixing seat of the extractor is connected to the board and the subrack outer frame.

10. The subrack according to claim 9, wherein the subrack comprises a plurality of boards and a plurality of extractors, and each board is connected to the fixing seats of two extractors.
